Europäisches Patentamt

European Patent Office

Office européen des brevets

(19)

(11) **EP 0 565 405 B1**

(12) **FASCICULE DE BREVET EUROPEEN**

(45) Date de publication et mention
de la délivrance du brevet:
**20.01.1999 Bulletin 1999/03**

(51) Int Cl.⁶: **G01R 31/36**

(21) Numéro de dépôt: **93400814.5**

(22) Date de dépôt: **30.03.1993**

(54) **Simulateur notamment de piles thermiques**

Simulator für thermische Spannungsquelle

Simulator for thermic cell

(84) Etats contractants désignés:
**BE CH DE ES GB IT LI NL SE**

(30) Priorité: **08.04.1992 FR 9204302**

(43) Date de publication de la demande:
**13.10.1993 Bulletin 1993/41**

(73) Titulaire: **AEROSPATIALE Société Nationale
Industrielle
75781 Paris Cédex 16 (FR)**

(72) Inventeurs:
• **Leon, Serge**
 **F-94230 Cachan (FR)**
• **Grain, Patrick**
 **F-78280 Guyancourt (FR)**
• **Bard, Serge**
 **F-94230 Cachan (FR)**

(74) Mandataire: **Joly, Jean-Jacques et al
Cabinet Beau de Loménie
158, rue de l'Université
75340 Paris Cédex 07 (FR)**

(56) Documents cités:
**EP-A- 0 359 237       DE-A- 3 420 889
DE-A- 3 823 640**

• **Week 8929, Derwent Publications Ltd., London,
GB; AN 89213201**

**Description**

La présente invention concerne un simulateur destiné principalement mais non exclusivement à la mise au point de dispositifs comportant des piles thermiques.

Les piles thermiques se présentent sous la forme d'un boîtier métallique, parfaitement hermétique, généralement cylindrique, équipé sur l'une de ses faces de bornes d'utilisation.

On retrouve dans une pile thermique les éléments essentiels d'une pile classique : cathode et anode métalliques, plaques isolantes imprégnées de dépolarisant ou d'électrolyte et assemblées en cellules identiques. Plusieurs de ces cellules sont empilées à l'intérieur du boîtier rendu étanche par sertissage puis soudure du capot portant les bornes d'utilisation.

La particularité d'une pile thermique consiste notamment dans le fait que l'électrolyte se trouve sous forme solide et qu'aucune Force ElectroMotrice (FEM) ne peut s'établir tant que n'a pas été provoquée la fusion de cet électrolyte. Cette fusion de l'électrolyte, c'est-à-dire l'activation de la pile, est assurée par l'inflammation de disques formés d'une composition pyrotechnique placée entre chaque cellule élémentaire de la pile et initiée par l'amorçage d'un inflammateur électrique.

Cette particularité physique des piles thermiques entraîne en particulier des caractéristiques singulières sur le plan électrique comme la variation, dans de très grandes proportions, des deux paramètres classiques d'une pile, sa FEM et sa résistance interne, et ceci sur une durée très courte, de quelques dizaines à quelques centaines de secondes, comprise entre l'activation de cette pile et sa fin de vie active.

Cette très brève durée de vie pendant laquelle la pile thermique est active présente un très grave inconvénient dans les phases de mise au point et d'essai des dispositifs comportant ces piles. En effet, pendant ces phases, il faut pouvoir assurer, pendant parfois plusieurs heures, l'alimentation de ces dispositifs et l'emploi de véritables piles thermiques entraînerait alors un coût d'essais prohibitif. De plus, les conditions de sécurité contraignantes entourant l'utilisation d'un tel dispositif pyrotechnique ainsi que les difficultés de mise en oeuvre de ce type de composant, font qu'il est très difficile, sinon impossible de l'employer lors des phases de mise au point puis d'essais ou de tests. Lors des essais, le concepteur ou l'intégrateur est donc réduit à substituer à la pile thermique les matériels de mesure à sa disposition.

Trois types de matériels sont aujourd'hui disponibles pour procéder à cette substitution :

- Une alimentation fixe à régulation série ou à découpage.

Elle fournit une tension (FEM quasiment parfaite) fixe, (éventuellement commutable par une commande tout ou rien) quel que soit la charge appliquée, c'est-à-dire quel que soit le courant débité :

On a alors ,

$$U_{pile} = E_{alim} = C^{te}, \; \forall t, \forall I_{débité}$$

- Une alimentation programmable par bus normalisé IEEE488.

Pilotée à partir d'un calculateur, ce type d'alimentation délivre une tension variable fonction de mots de commande numériques reçus et interprétés par le coupleur normalisé de l'appareil :

En ce cas,

$$U_{pile} = E_{alim} = k_1 i, \; \forall I_{débité}, k_1 i \in \mathbb{R}$$

- Une alimentation programmable par une tension de consigne analogique.

Le signal de consigne est fourni, par exemple, par un générateur de signaux aléatoires, la tension de sortie de l'alimentation peut décrire une forme d'onde variable (image de la consigne), modifiable à volonté, mais toujours indépendante de la charge appliquée :

Soit,

$$U_{pile} = E_{alim} = k_2 \, C_{Eg}(t), \; \forall I_{débité}, \; k_2 \in \mathbb{R}$$

Quelle que soit la solution choisie ci-dessus, la tension fournie est toujours une FEM quasiment parfaite, même si elle évolue dans le temps. En aucun cas le courant débité ne peut faire varier le niveau de tension de sortie, ce qui n'est pas représentatif du comportement d'une pile thermique.

Il est donc clair qu'il existe un besoin de disposer d'un système capable de simuler de façon plus exacte le comportement des piles thermiques afin de faciliter la mise au point des équipements qui leur sont raccordés : convertisseur d'alimentation, vérins de commande par exemple.

On connaît par la demande DE-A-3 420 889 un simulateur de piles classiques de structure conforme au préambule de la revendication 1.

Un but de l'invention est de proposer un simulateur de piles thermiques permettant de reproduire le plus fidèlement possible les variations de FEM et de résistance interne observées, pendant le cycle actif de ces piles, dans des conditions réelles de fonctionnement.

Un autre but de l'invention est de réaliser un dispositif simple et fiable dont la mise en oeuvre soit aisée.

Ces buts sont atteints par un simulateur défini par la revendication 1.

Cette variation de la FEM et de la résistance interne d'une pile ou plus généralement d'un générateur de tension à résistance interne dynamique permet de simuler de façon représentative le comportement réel de tels dispositifs pour lesquels, spécialement dans le cas de piles thermiques, les variations de ces paramètres sont importants.

L'ensemble informatique comporte une mémoire dans laquelle sont emmagasinés les profils de simulation, un interface opérateur qui assure le contrôle général du simulateur étant en outre relié à cet ensemble informatique. En outre, cet ensemble est relié à une plateforme informatique qui permet un contrôle général du simulateur ainsi qu'une acquisition à distance des différents profils de simulation et une modélisation.

Ces différents éléments constituent un appareil de simulation d'un générateur de tension à résistance interne dynamique particulièrement simple d'emploi et de réalisation et permettant notamment une très grande variation de cette résistance interne dans une large gamme de valeurs tout en étant traversée par un courant de charge pouvant être supérieur à 10 ampères.

La consigne de tension pile $C_{Upile}$ est obtenue par la différence entre la consigne de FEM $C_{Eg}$ et une consigne $C_{RI}$ représentative de la chute de tension dans la résistance interne de la pile et obtenue elle-même par la multiplication analogique de la consigne de résistance interne $C_{Rg}$ provenant d'une transformation numérique/analogique de la valeur numérique correspondante délivrée par l'ensemble informatique avec la consigne de courant débité $C_{Idébité}$ résultant d'une mesure analogique du courant débité par l'alimentation de puissance programmable.

Cette mise en oeuvre d'une méthode mixte, à la fois analogique et numérique, simplifie la réalisation du simulateur et permet une utilisation directe des profils de simulation disponibles sous forme de fichiers numériques dans l'ensemble informatique.

Avantageusement, ce simulateur pourra être utilisé dans une forme mono-tension 24V ou multi-tensions, notamment bi-tensions 10V/36V, dans des opérations d'intégration de missile pour permettre ainsi de rejouer autant de fois que nécessaire les essais de tirs et ceci sans consommer de nouvelle pile thermique.

D'autres caractéristiques et avantages ressortiront mieux de la description qui va suivre faite en référence aux dessins annexés sur lesquels :

- la figure 1 est un schéma synoptique général d'un simulateur de pile selon l'invention,
- la figure 2 est un schéma de principe d'une carte de simulation pile du simulateur de la figure 1,
- la figure 3 est un schéma simplifié d'un simulateur de piles thermiques bi-tensions conforme à l'invention.

En première approximation, il peut être considéré que les 2 paramètres essentiels d'une pile thermique sont sa FEM et sa résistance Rg. L'équation pour modéliser une pile thermique est donc la suivante :

$$U_{pile} = Eg - (Rg \times I_{débité})$$

Les paramètres Eg et Rg sont deux variables pouvant être décrites par des fonctions du temps, $C_{Eg}(t)$ et $C_{Rg}(t)$ qui sont, soit fournies par le fabricant de la pile, soit le résultat d'un dépouillement d'essais de piles thermiques réelles.

$$Eg = \alpha \times C_{Eg}(t), \quad \alpha \in \mathbb{R}$$

$$Rg = \beta \times C_{Rg}(t), \quad \beta \in \mathbb{R}$$

Le paramètre $I_{débité}$ dépend de la valeur instantanée du couple (Eg,Rg) et d'une charge imposée par tous les équipements connectés à un instant donné aux bornes de cette pile délivrant une tension $U_{pile}$.

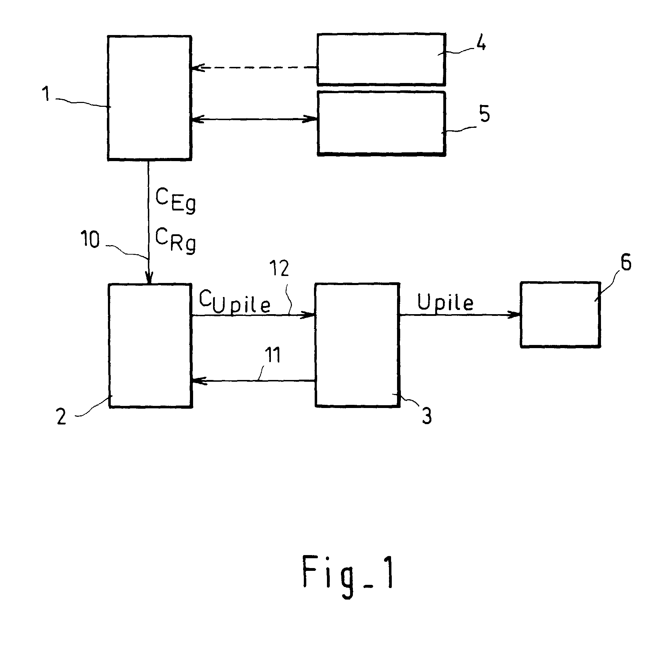

La figure 1 montre un schéma de principe d'un simulateur de pile selon l'invention. Un tel simulateur est constitué de trois parties principales : un ensemble informatique 1, une carte électronique de simulation 2 et une alimentation continue de puissance 3.

L'ensemble informatique 1 est constitué de façon connue d'un calculateur par exemple à microprocesseur dont la puissance est déterminée afin de permettre la réalisation des différentes opérations nécessaires à la simulation d'une pile thermique. Il s'agit notamment de la mémorisation temporaire (dans une mémoire de type RAM) ou permanente (dans une mémoire morte) d'un ou plusieurs profils de simulation, c'est-à-dire de suites d'échantillons (Eg,Rg) donnant pour chaque instant (t) d'une simulation et ce, pendant toute sa durée, les valeurs respectives instantanées de la FEM Eg et de la résistance interne Rg d'une pile donnée.

Le calculateur doit en outre permettre l'exécution de la simulation, c'est-à-dire la lecture séquentielle, de manière périodique ou non, de ces différents échantillons. Chaque échantillon fixe à un instant donné les valeurs des 2 paramètres $C_{Eg}$ et $C_{Rg}$ pour la carte électronique de simulation 2. La périodicité des mises à jour des paramètres $C_{Eg}$, $C_{Rg}$ est fonction du processus de simulation s'exécutant sur l'ensemble informatique 1. Plusieurs algorithmes sont ainsi possibles, mettant en oeuvre un échantillonnage à période fixe ou incrémental par exemple.

De préférence, un panneau de commande 4 relié à l'ensemble informatique 1 est prévu pour permettre une gestion du simulateur par un opérateur ainsi que la génération en interne, au niveau de l'ensemble informatique, des profils de simulation à partir de données entrées par l'opérateur. Avantageusement, ce panneau de commande peut comporter des dispositifs de sélection manuels pour attribuer à la FEM et à la résistance interne des valeurs fixes, afin de permettre un fonctionnement du simulateur en un point fixe.

En outre, il peut être prévu la connexion de cet ensemble informatique 1 avec une ou plusieurs plateformes informatique 5, au travers d'un bus de communication, pour permettre soit une commande à distance du simulateur soit un téléchargement des différents profils de simulation.

La carte de simulation 2 est racordée d'une part à l'ensemble informatique 1 par un bus numérique 10 sur lequel transitent les valeurs des paramètres $C_{Eg}$ et $C_{Rg}$ et d'autre part à l'alimentation de puissance 3. Elle permet, à partir de ces valeurs de $C_{Eg}$ et $C_{Rg}$ et d'une mesure du courant 11 débité par l'alimentation de puissance, courant fixé par une charge 6 qui lui est connectée, d'élaborer une tension de consigne pile $C_{Upile}$ 12 pour cette alimentation de puissance 3.

L'alimentation continue de puissance 3 est une alimentation classique programmable par une tension analogique normalisée, 0 à 10 volts par exemple, qui délivre une tension pile $U_{pile}$ à partir de la tension de consigne pile $C_{Upile}$ fournie par la carte de simulation 2. Le choix de cette alimentation, alimentation à régulation série ou alimentation à découpage par exemple, est réalisé en fonction de la bande passante globale demandée par le simulateur, ce choix étant à la portée de tout homme de l'art qui peut en outre, sans aucune difficulté particulière, y adjoindre divers dispositifs de sécurité comme des protections contre les surtensions, contre les surintensités, ou encore une commutation du réseau de puissance.

Si l'alimentation est munie d'une option mesure de courant par tension analogique normalisée, on peut s'affranchir de l'utilisation d'un shunt extérieur ou de tout autre moyen de mesure de courant nécessaire dans le dispositif selon l'invention, pour évaluer le courant absorbé par la charge 6.

Le simulateur peut bien sûr simuler simultanément plusieurs piles thermiques, il est alors équipé d'autant de cartes de simulation pile 2 et d'alimentations de puissance 3 que de voies de simulation. La puissance de l'ensemble informatique 1 doit alors être dimensionnée pour commander simultanément toutes ces voies.

En outre, il doit être noté qu'un tel dispositif selon l'invention, qui constitue un système totalement autonome, peut non seulement simuler des piles thermiques mais tout autre générateur de tension à résistance interne dynamique.

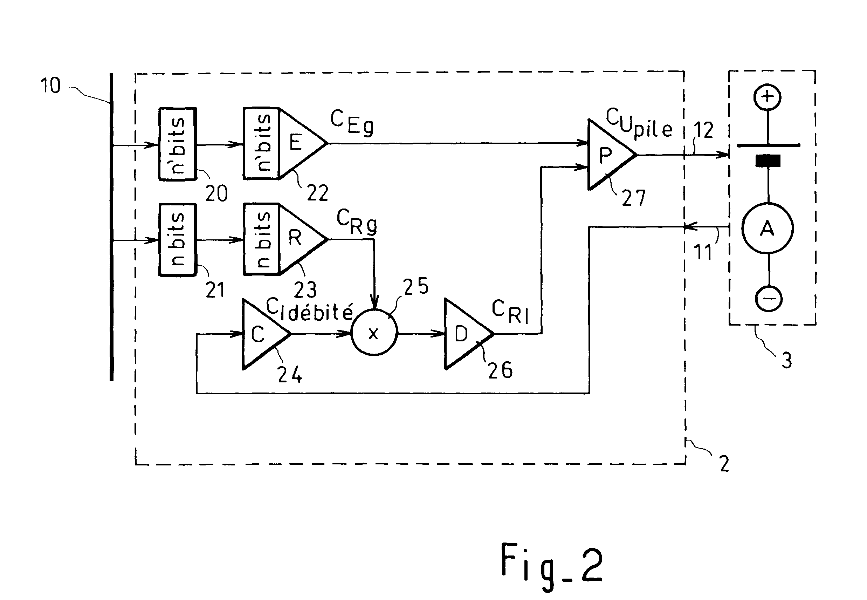

La figure 2 représente un schéma de principe de la carte de simulation 2 du simulateur selon l'invention.

Cette carte électronique est raccordée à l'ensemble informatique 1 par le bus numérique 10. C'est par ce bus que l'ensemble informatique 1 vient, à des instants définis par l'algorithme de simulation, charger les valeurs (numériques) des deux consignes $C_{Eg}$ et $C_{Rg}$ sur la carte de simulation 2.

A chaque paramètre $C_{Eg}$ ou $C_{Rg}$ est associé un registre 20,21 dont le contenu est transformé par deux Convertisseurs Numérique Analogique (CNA) 22,23 en des tensions analogiques normalisées. Le nombre de bits de ces convertisseurs est fonction de la résolution nécessaire, compte tenu de la dynamique des deux grandeurs physiques Eg et Rg définie par respectivement $E_{gMAX}$ et $R_{gMAX}$.

La valeur du courant absorbé par la charge 6 $I_{débité}$ est mesurée par une fonction ampèremètre A, la mesure de courant étant du type analogique (transformation du courant en tension).

Cette fonction A peut être réalisée de différentes manières comme par exemple à partir d'un véritable ampèremètre ou bien encore comme indiqué précédemment par un shunt ou directement grâce à la fonction mesure de courant disponible sur certaines alimentations de puissance programmables.

Le résultat de cette mesure 11 attaque la carte de simulation 2 sur un étage à amplificateur d'instrumentation 24 dont le gain C permet d'aligner la dynamique de la mesure du courant sur celle des autres consignes $C_{Eg}$ et $C_{Rg}$ obtenues en sortie des convertisseurs 22 et 23. En sortie de l'amplificateur 24 on obtient une nouvelle consigne de courant $C_{Idébité}$. Il doit être noté que l'utilisation d'un amplificateur d'instrumentation n'est pas obligatoire mais préférable pour faciliter cet alignement de dynamique.

Cette consigne $C_{Idébité}$ ainsi que la consigne $C_{Rg}$ constituent les deux entrées d'un multiplieur analogique 25 qui élabore donc le produit $C_{Rg} \times C_{Idébité}$ représentatif de la chute de tension dans la résistance interne de la pile $R_g$. Un second amplificateur 26 placé en sortie de ce multiplieur 25 dont le gain D permet ici encore un contrôle de la dynamique de l'ensemble - on choisit ce gain D de telle sorte qu'il vérifie la relation $E_{gMAX} = R_{gMAX} I_{débitéMAX}$ - et délivre alors une consigne $C_{RI}$ qui est soustraite à la consigne $C_{Eg}$ au niveau d'un amplificateur-soustracteur 27 dont le gain P permet d'obtenir en sortie une tension normalisée de consigne $C_{Upile}$ 12 pour commander l'alimentation continue de puissance 3.

De cette façon, on asservit la tension de sortie de l'alimentation 3 au trois paramètres $E_g$, $R_g$ et $I_{débité}$ ce qui permet de reproduire artificiellement, à partir d'une alimentation tout à fait classique (programmable par tension analogique normalisée), un comportement similaire à celui d'une pile thermique modélisée par l'équation $U_{pile} = E_g - (R_g \times I_{débité})$.

En effet, la chute de tension dans la résistance interne de la pile, c'est-à-dire le terme $(R_g \times I_{débité})$ de l'équation de modélisation ci-dessus, est simulée en soustrayant en permanence à la consigne $C_{Eg}$ une quantité équivalente à une valeur en volts égale au produit $(R_g \times I_{débité})$.

Pour ce faire, le courant débité est constamment mesuré et cette mesure est exploitée sous la forme d'une tension analogique normalisée image de $I_{débité}$, $C_{Idébité}$. A partir des deux grandeurs $C_{Rg}$ et $C_{Idébité}$ on calcule la consigne $C_{RI}$ significative de la chute de tension dans la résistance interne de la pile.

$$C_{RI} = \gamma \times (C_{Rg} \times C_{Idébité}), \gamma \, \varepsilon \, R$$

$$C_{RI} = \delta \times (R_g \times I_{débité}), \delta \, \varepsilon \, R$$

Les 4 coefficients $\alpha$, $\beta$, $\gamma$, et $\delta$ possèdent des valeurs qui garantissent l'intégrité des transformations entre les grandeurs physiques, volt, ohm, ampère et celles des différentes consignes.

A titre indicatif, un simulateur de piles thermiques bi-tensions 10V et 36V et un simulateur de pile thermique mono-tension 24V ont été réalisés.

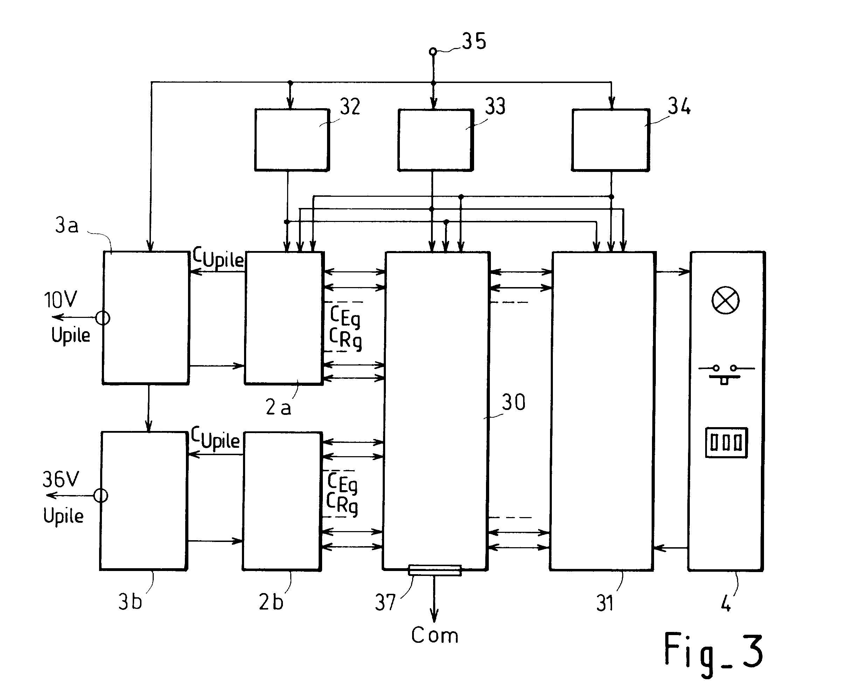

La figure 3 montre un schéma de principe de la réalisation bi-tensions. On retrouve bien évidemment les différents éléments décrits précédemment avec toutefois deux cartes de simulation pile, la première 2a élaborant une consigne $C_{Upile}$ pour une alimentation de puissance 3a délivrant une tension nominale de 10V et la seconde 2b élaborant une consigne pour une alimentation de puissance 3b délivrant une tension nominale de 36V. L'ensemble informatique 1 comporte une carte unité centrale 30 et une carte d'entrée-sortie 31. Cette carte 30 et les deux cartes de simulation pile 2a,2b sont reliées entres elles par un bus standard du type VME. La carte 31 est reliée à la carte unité centrale par un bus numérique parallèle d'un autre type.

Des cartes d'alimentation 32, 33 et 34 permettent à partir d'une tension secteur alternative 35, par exemple de 220V, de fournir des tensions de référence pour l'ensemble ces cartes, les alimentations de puissance étant reliées directement à la tension secteur. L'interface opérateur 4 est constitué par un ensemble de commande et de visualisation relié à la carte d'entrée-sortie 31. Plus précisément, cet ensemble 4 comporte des boutons poussoirs destinés notamment à mettre en route la simulation et des éléments à roues codeuses pour l'entrée par l'opérateur des caractéristiques de FEM et de résistance interne dans un mode de fonctionnement où les valeurs de tension et de résistance interne sont fixes. Une liaison de communication 37, (par exemple du type RS 232), reliée directement à la carte unité centrale 30, en autorisant une liaison avec une plate-forme informatique extérieure, permet une télécommande des différentes fonctions du simulateur ainsi que le chargement éventuel des profils de simulation qui sont normalement présents dans la mémoire du simulateur au niveau de la carte d'unité centrale 30.

**Revendications**

1. Simulateur de piles, notamment pour piles thermiques, délivrant sur ses bornes de sortie une tension ($U_{pile}$) fonction d'une part d'un courant ($I_{débité}$) débité dans une charge connectée à ces bornes de sortie et d'autre part de paramètres de force électromotrice ($E_g$) et de résistance interne ($R_g$), les valeurs successives de ces deux paramètres, durant un cycle de vie actif d'une pile donnée, dans des conditions réelles de fonctionnement, déterminant des profils de simulation, caractérisé en ce que ces profils de simulation sont délivrés par un ensemble informatique (1) sous la forme d'une consigne de force électromotrice ($C_{Eg}$) et d'une consigne de résistance interne ($C_{Rg}$) fournies à une carte de simulation pile (2) qui à son tour délivre, à une alimentation continue de puissance (3) programmable par tension, une consigne de tension pile ($C_{Upile}$) déterminée à partir d'une mesure du courant débité par cette alimentation (3) et des consignes de force électromotrice et de résistance interne reçues de l'ensemble informatique (1), afin d'élaborer la tension de sortie du simulateur ($U_{pile}$) en sortie de cette alimentation de puissance programmable (3).

2. Simulateur selon la revendication 1, caractérisé en ce que ledit ensemble informatique (1) comporte une mémoire dans laquelle sont emmagasinés les profils de simulation, un interface opérateur (4) qui assure le contrôle général du simulateur étant en outre relié à cet ensemble informatique (1).

3. Simulateur selon la revendication 1 ou la revendication 2, caractérisé en ce que ledit ensemble informatique (1) est en outre relié, par l'intermédiaire d'une liaison de communication, à une plate-forme informatique (5) qui permet un contrôle général du simulateur ainsi qu'une acquisition à distance des différents profils de simulation.

4. Simulateur selon la revendication 1, caractérisé en ce que ladite consigne de tension pile ($C_{Upile}$) est obtenue par la différence entre la consigne de force électromotrice ($C_{Eg}$) et une consigne ($C_{RI}$) représentative de la chute de tension dans la résistance interne de la pile et obtenue elle-même par la multiplication de la consigne de résistance interne ($C_{Rg}$) par une consigne de courant débité ($C_{Idébité}$) image du courant mesuré ($I_{débité}$).

5. Simulateur selon la revendication 4, caractérisé en ce que ladite consigne ($C_{RI}$) est obtenue par la multiplication analogique de la consigne de résistance interne ($C_{Rg}$) provenant d'une transformation numérique/analogique de la valeur numérique correspondante délivrée par l'ensemble informatique (1) avec la consigne de courant débité ($C_{Idébité}$) résultant d'une mesure analogique du courant débité.

6. Simulateur selon la revendication 5, caractérisé en ce que ladite mesure analogique du courant débité est obtenue directement à partir de la sortie de mesure de courant de l'alimentation de puissance (3).

7. Simulateur selon la revendication 5, caractérisé en ce que ladite mesure analogique du courant débité est obtenue aux bornes d'un shunt.

**8.** Simulateur selon la revendication 5, caractérisé en ce que ladite mesure analogique du courant débité est obtenue directement grâce à la fonction mesure de courant de l'alimentation de puissance programmable.

**9.** Simulateur selon l'une quelconque des revendications 1 à 8, caractérisé en ce qu'il comporte plusieurs voies de simulation, chacune comportant une alimentation de puissance programmable (3) et une carte de simulation pile (2), l'ensemble informatique (1) délivrant en outre autant de consignes de force électromotrice ($C_{Eg}$) et de résistance interne ($C_{Rg}$) qu'il existe de voies de simulation.

**10.** Simulateur de piles thermiques multi-tensions délivrant sur ses bornes de sortie des tensions ($U_{pile}$), chaque tension étant fonction d'une part d'un courant ($I_{débité}$) débité dans une charge connectée à ces bornes de sortie et d'autre part de paramètres de force électromotrice ($E_g$) et de résistance interne ($R_g$), les valeurs successives de ces deux paramètres, durant un cycle de vie actif d'une pile donnée, dans des conditions réelles de fonctionnement, déterminant des profils de simulation délivres par un ensemble informatique (30, 31) sous la forme d'une consigne de force électromotrice ($C_{Eg}$) et d'une consigne de résistance interne ($C_{Rg}$) fournies à des cartes de simulation pile (2a,2b) qui à leur tour délivrent, à des alimentations continues de puissance (3a, 3b) programmables par tension, des consignes de tension pile ($C_{Upile}$) déterminées à partir d'une mesure du courant débité par ces alimentations et des consignes de force électromotrice et de résistance interne reçues de l'ensemble informatique (30, 31), afin d'élaborer les tensions de sortie ($U_{pile}$) du simulateur en sortie de ces alimentations de puissance programmables (3a,3b).

**11.** Simulateur selon la revendication 10, dont l'ensemble informatique comporte une carte d'unité centrale (30) munie d'une mémoire et d'une liaison de communication (37) et une carte d'entrée/sortie (31) relié à une interface utilisateur (4) recevant des commandes d'un opérateur et délivrant des visualisations pour cet opérateur afin de permettre un contrôle général du simulateur ainsi que le chargement éventuel de la mémoire au travers de la liaison de communication (37), et dont ladite carte d'unité centrale (30), ladite carte d'entrée/sortie (31) et lesdites cartes de simulation pile (2a,2b) sont reliées à un bus standard informatique autour duquel le simulateur est organisé.

## Patentansprüche

**1.** Simulator für Spannungsquellen, insbesondere für thermische Spannungsquellen, der am Ausgang seiner Anschlußklemmen eine Spannung ($U_{pile}$) als Funktion zum einen eines in einer an den Ausgangsklemmen angeschlossenen Last umgesetzten Stromes ($I_{debite}$) und zum anderen der Parameter elektromotorische Kraft ($E_g$) und innerer Widerstand ($R_g$), wobei die aufeinanderfolgenden Werte der beiden Parameter, die während eines aktiven Lebenslaufes einer gegebenen Spannungsquelle unter realen Betriebsbedingungen andauern, Simulationsprofile festlegen, dadurch gekennzeichnet,
daß die Simulationsprofile von einer Datenverarbeitungseinheit (1) in der Form eines Einstellwertes für die elektromotorische Kraft ($C_{Eg}$) und eines Einstellwertes für den inneren Widerstand ($C_{Rg}$) geliefert werden, die einer Spannungsquellensimulationsschaltung (2) zugeführt werden, die wiederum einer durch eine Spannung einstellbaren kontinuierlichen Leistungsversorgung (3) einen Spannungseinstellwert für die Spannungsquelle ($C_{Upile}$), der anhand einer Messung des umgesetzten Stromes durch die Versorgung (3) bestimmt wird, und Einstellwerte für die elektromotorische Kraft und den inneren Widerstand, die von der Datenverarbeitungseinheit (1) empfangen werden, liefert, um die Ausgangsspannung des Simulators ($U_{pile}$) am Ausgang der einstellbaren Leistungsversorgung (3) zu bestimmen.

**2.** Simulator nach Anspruch 1, dadurch gekennzeichnet, daß die Datenverarbeitungseinheit (1) einen Speicher, in dem die Simulationsprofile gespeichert sind und eine Bedienerschnittstelle (4) aufweist, die die allgemeine Steuerung des Simulators garantiert und außerdem mit der Datenverarbeitungseinheit (1) verbunden ist.

**3.** Simulator nach Anspruch 1 oder 2, dadurch gekennzeichnet, daß die Datenverarbeitungseinheit (1) durch eine Kommunikationsschnittstelle mit einer Datenverarbeitungsplattform (5) verbunden ist, die eine allgemeine Steuerung des Simulators ebenso wie ein Laden verschiedener Simulationsprofile von der Peripherie aus ermöglicht.

**4.** Simulator nach Anspruch 1, dadurch gekennzeichnet, daß der Spannungseinstellwert für die Spannungsquelle ($C_{Upile}$) aus der Differenz zwischen dem Einstellwert für die elektromotorische Kraft ($C_{Eg}$) und einem Einstellwert ($C_{RI}$) gebildet wird, der den Spannungsabfall über dem inneren Widerstand der Spannungsquelle zeigt und durch Multiplikation des Einstellwertes für den inneren Widerstand ($C_{Rg}$) mit einem Einstellwert für den umgesetzten Strom ($C_{Idebite}$), der ein Abbild des gemessenen Stromes ($I_{debite}$) ist, erhalten wird.

5. Simulator nach Anspruch 4, dadurch gekennzeichnet, daß der Einstellwert ($C_{RI}$) durch analoge Multiplikation des Einstellwertes für den inneren Widerstand ($C_{Rg}$), der von einer Digital/Analog-Wandlung eines entsprechenden digitalen Wertes, der von der Datenverarbeitungseinheit (1) geliefert wird, kommt, mit dem Einstellwert für den umgesetzten Strom ($C_{Idebite}$), der aus einer analogen Messung des umgesetzten Stromes resultiert, erhalten wird.

6. Simulator nach Anspruch 5, dadurch gekennzeichnet, daß die analoge Messung des umgesetzten Stromes direkt vom Ausgang einer Strommessung der Leistungsversorgung (3) erhalten wird.

7. Simulator nach Anspruch 5, dadurch gekennzeichnet, daß die analoge Messung des umgesetzten Stromes an den Anschlußklemmen eines Shunts erhalten wird.

8. Simulator nach Anspruch 5, dadurch gekennzeichnet, daß die analoge Messung des umgesetzten Stromes direkt aus einer Strommeßfunktion der einstellbaren Leistungsversorgung erhalten wird.

9. Simulator nach einem der Ansprüche 1 bis 8, dadurch gekennzeichnet, daß er mehrere Simulationsbahnen aufweist, wobei jede eine einstellbare Leistungsversorgung (3) und eine Spannungsquellensimulationsschaltung (2) aufweist und die Datenverarbeitungseinheit (1) außerdem so viele Einstellwerte für die elektromotorische Kraft ($C_{Eg}$) und den inneren Widerstand ($C_{Rg}$) liefert, wie Simulationsbahnen vorhanden sind.

10. Simulator für thermische Spannungsquellen mit Multi-Spannungen, der an seinem Ausgang Spannungen ($U_{pile}$) liefert, wobei jede Spannung zum einen eine Funktion eines Stromes ($I_{debite}$), der in einer mit dem Ausgang verbundenen Last umgesetzt wird, und zum anderen eine Funktion von den Parametern elektromotorische Kraft (Eg) und innerer Widerstand ($R_g$) ist und die aufeinanderfolgenden Werte für die beiden Parameter einen aktiven Lebenslauf einer gegebenen Spannungsquelle unter realen Betriebsbedingungen andauern und Simulationsprofile festlegen, die von einer Datenverarbeitungseinheit (30, 31) als Einstellwert für die elektromotorische Kraft ($C_{Eg}$) und Einstellwert für den inneren Widerstand ($C_{Rg}$) den Spannungsquellensimulationsschaltungen (2a, 2b) zugeführt werden, die wiederum in ihrer Spannung einstellbaren kontinuierlichen Leistungsversorgungen (3a, 3b) Spannungseinstellwerte für die Spannungsquellen ($C_{Upile}$), die über eine Messung des umgesetzten Stromes durch die Versorgungen bestimmt werden, und Einstellwerte für die elektromotorische Kraft und den inneren Widerstand, die von der Datenverarbeitungseinheit (30, 31) empfangen werden, liefert, um die Ausgangsspannungen ($U_{pile}$) des Simulators am Ausgang der einstellbaren Leistungsversorgungen (3a, 3b) zu ermitteln.

11. Simulator nach Anspruch 10, dessen Datenverarbeitungseinheit eine Schaltung für eine Zentraleinheit (30), die mit einem Speicher und einer Kommunikationsschnittstelle (37) ausgestattet ist, und eine Eingangs-Ausgangs-Schaltung (31) aufweist, die mit einer Benutzerschnittstelle (4) verbunden ist, die Befehle eines Benutzers empfängt und Anzeigen für den Benutzer liefert, um eine allgemeine Steuerung des Simulators ebenso wie das evtl. Laden des Speichers über die Kommunikationsschnittstelle (37) zu ermöglichen, und dessen Schaltung für die Zentraleinheit (30), dessen Eingangs-Ausgangs-Schaltung (31) und dessen Spannungsquellensimulationsschaltungen (2a, 2b) mit einem Standard-Datenverarbeitungsbus verbunden sind, über den der Simulator organisiert wird.

## Claims

1. A battery simulator, in particular for thermal batteries, the simulator delivering a voltage ($U_{bat}$) across its output terminals, each voltage being, on the one hand, a function of a current ($I_{out}$) delivered into a load connected to its output terminals, and on the other hand, an e.m.f. parameter ($E_g$) and an internal resistance parameter ($R_g$), the successive values taken by said two parameters during an active life cycle of a given battery, under real operating conditions, determining simulation profiles, characterised in that such simulation profiles are delivered by a computer equipment (1) in the form of a reference e.m.f. ($C_{Eg}$) and of a reference internal resistance ($C_{Rg}$) to a battery simulation card (2) which in turn delivers a battery voltage reference ($C_{Ubat}$) to a voltage-programmable DC power supply (3), where ($C_{Ubat}$) is determined on the basis of a measurement of the current delivered by said power supply (3) and of both the reference e.m.f. and the reference internal resistance as received from the computer equipment (1), thereby causing the output of said programmable power supply (3) to deliver the output voltage ($C_{Ubat}$) of the simulator.

2. A simulator according to claim 1, characterised in that said computer equipment (1) includes a memory storing the simulation profiles, an operator interface (4) providing overall control of the simulator being connected to said computer equipment (1).

**3.** A simulator according to claim 1 or claim 2, characterised in that said computer equipment (1) is also connected via a communications link to a computer platform (5) and also enables overall control of the simulator to be provided, and in addition enables different simulation profiles to be acquired remotely.

**4.** A simulator according to claim 1, characterised in that said battery voltage reference ($C_{Ubat}$) is obtained by taking the difference between the reference e.m.f. ($C_{Eg}$) and a reference ($C_{RI}$) representative of the voltage drop across the internal resistance of the battery, itself obtained by multiplying the reference for the internal resistance ($C_{Rg}$) by a delivered current reference ($C_{Iout}$) which is an image of the measured current ($I_{out}$).

**5.** A simulator according to claim 4, characterised in that said reference ($C_{RI}$) is obtained by analog multiplication of the internal resistance reference ($C_{Rg}$) obtained by digital-to-analog transformation of the corresponding digital value as delivered by the computer equipment (1) multiplied by the delivered current reference ($C_{Iout}$) that results from an analog measurement of the delivered current.

**6.** A simulator according to claim 5, characterised in that said analog measurement of the delivered current is obtained directly from the current measurement output of the power supply (3).

**7.** A simulator according to claim 5, characterised in that said analog measurement of the delivered current is obtained by means of a shunt.

**8.** A simulator according to claim 5, characterised in that said analog measurement of the delivered current is obtained directly by means of a current measurement facility provided by the programmable power supply.

**9.** A simulator according to any one of claims 1 to 8, characterised in that it includes a plurality of simulation channels, each having its own programmable power supply (3) and its own battery simulation card (2), the computer equipment (1) delivering as many e.m.f. references ($C_{Eg}$) and internal resistance references ($C_{Rg}$), as there are simulation channels.

**10.** A multivoltage thermal battery simulator delivering a voltage ($U_{bat}$) across its output terminals, each voltage being a function, on the one hand, of a current ($I_{out}$) delivered into a load connected to its output terminals, and on the other hand, an e.m.f. parameter ($E_g$) and an internal resistance parameter ($R_g$), the successive values taken by said two parameters during an active life cycle of a given battery, under real operating conditions, determining simulation profiles as delivered by a computer equipment (30, 31) in the form of a reference e.m. f. ($C_{Eg}$) and of a reference internal resistance ($C_{Rg}$) to battery simulation cards (2a, 2b) which in turn deliver battery voltage references ($C_{Ubat}$) to voltage-programmable DC power supplies (3a, 3b), where ($C_{Ubat}$) is determined on the basis of a measurement of the current delivered by said power supplies and of both the reference e.m.f. and the reference internal resistance as received from the computer equipment (30, 31), thereby causing the output of said programmable power supply (3a, 3b) to deliver the output voltage ($C_{Ubat}$) of the simulator.

**11.** A simulator according to claim 10, whose computer equipment comprises a central unit card (30) provided with a memory and with a communications link (37) and an input/output card (31) connected to a user interface (4) receiving commands from an operator and delivering information to said operator in order to make overall control of the simulator possible, and also optionally loading the memory by means of the communications link (37) et whose central unit card (30), input/output card (31) and battery simulation cards (2a, 2b) are connected to a standard computer bus about which the simulator is organised.

Fig_1

Fig_2

EP 0 565 405 B1

Fig_3

EP 0 565 405 B1